# EUROPÄISCHE PATENTANMELDUNG

(11) **EP 0 530 564 A1**
(43) Veröffentlichungstag der Anmeldung: **10.03.1993**
(21) Anmeldenummer: 92113845.9
(22) Anmeldetag: 13.08.1992
(51) Int. Cl.: H05K 3/06

(54) **Verfahren zur Herstellung von Leiterplatten**

(30) Priorität: 05.09.1991 DE 4129532
(71) Anmelder: SIEMENS AKTIENGESELLSCHAFT, D-80333 München (DE)
(72) Erfinder: Mattelin, Antoon, B-8020 Oostkamp (BE)

(57) **Zusammenfassung**

Auf ein Substrat (1) werden nacheinander eine erste Metallschicht (3) und eine Ätzresistschicht (4) aufgebracht, worauf diese Ätzresistschicht (4) mittels elektromagnetischer Strahlung, vorzugsweise mittels Laserstrahlung, in den unmittelbar an das spätere Leiterbild angrenzenden Bereichen entfernt und die dadurch freigelegte erste Metallschicht (3) weggeätzt wird. Die dem Leiterbild entsprechenden Bereiche der ersten Metallschicht (3) oder der Ätzresistschicht (4) werden dann kathodisch kontaktiert, worauf auf diese kathodisch kontaktierten Bereiche in einem galvanischen Metallabscheidungsbad eine zweite Metallschicht (8) aufgebracht wird. Gleichzeitig mit dem galvanischen Aufbau der zweiten Metallschicht (8) lösen sich in dem Metallabscheidungsbad die unerwünschten Bereiche der ersten Metallschicht (3) und gegebenenfalls der Ätzresistschicht (4) zwischen den Leiterbahnen vollständig auf.

## Beschreibung

Aus der EP-A-0 062 300 ist ein verfahren zur Herstellung von Leiterplatten bekannt, bei welchem eine ganzflächig auf eine Metallschicht aufgebrachte metallische Ätzresistschicht mittels eines Laserstrahls selektiv wieder entfernt wird und das Leiterbild durch Abätzen der derart freigelegten Metallschicht strukturiert werden kann. Um bei diesem bekannten Verfahren die Metallschicht zwischen den Leiterbahnen durch Ätzen vollständig entfernen zu können, muß zuvor die darüberliegende Ätzresistschicht ebenfalls vollständig entfernt werden. Diese Entfernung der Ätzresistschicht, die mit einem Laserstrahl vorgenommen wird, ist jedoch aufwendig und zeitraubend. Dies trifft insbesondere dann zu, wenn die Leiterbahnen relativ weit auseinander liegen und die Flächen der mit dem Laser abzutragenden Ätzresistschicht somit relativ groß sind.

Bei einem aus der US-A-4 943 346 bekannten Verfahren zur Herstellung von Leiterplatten werden im Unterschied zu dem vorstehend beschriebenen Verfahren nur die unmittelbar an das spätere Leiterbild angrenzenden Bereiche der Ätzresistschicht mittels elektromagnetischer Strahlung, vorzugsweise Laserstrahlung, entfernt. Die Konturbeschreibung mittels der elektromagnetischen Strahlung ist also als eine enge Umfahrung oder Umschreibung des Leiterbildes anzusehen, die im Hinblick auf die geringe Flächenausdehnung der abzutragenden Ätzresistschicht rasch vorgenommen werden kann. Die nicht dem Leiterbild entsprechenden Bereiche werden anodisch kontaktiert, worauf hier die Ätzresistschicht elektrolytisch abgetragen und die dadurch freigelegte Metallschicht weggeätzt werden kann.

Der im Anspruch 1 angegebenen Erfindung liegt das Problem zugrunde, das aus der US-A-4 943 346 bekannte Verfahren weiter zu vereinfachen.

Die mit der Erfindung erzielten Vorteile bestehen insbesondere darin, daß in den dem Leiterbild entsprechenden kathodisch kontaktierten Bereichen der Aufbau des Leiterbildes galvanisch in einem Metallabscheidungsbad vorgenommen werden kann und die unerwünschten Bereiche zwischen den Leiterbahnen sich dabei selbsttätig in dem Metallabscheidungsbad auflösen. Der Aufbau des Leiterbildes durch galvanische Metallabscheidung und die Entfernung der unerwünschten Bereiche zwischen den Leiterbahnen erfolgen also in einem einzigen Verfahrensschritt. Für die kathodische Kontaktierung der dem Leiterbild entsprechenden Bereiche müssen diese Bereiche elektrisch leitend miteinander verbunden werden, was jedoch durch eine entsprechende Gestaltung der Leiterbahnmuster und/oder durch Klemmen, Kontaktbrücken oder dergleichen problemlos erreicht werden kann. Gegebenenfalls können auch zur kathodischen Kontaktierung benutzte Verbindungsstege später wieder durchgetrennt werden.

Vorteilhafte Ausgestaltungen der Erfindung sind in den Ansprüchen 2 bis 20 angegeben. Ein Ausführungsbeispiel der Erfindung ist in der Zeichnung dargestellt und wird im folgenden näher beschrieben.

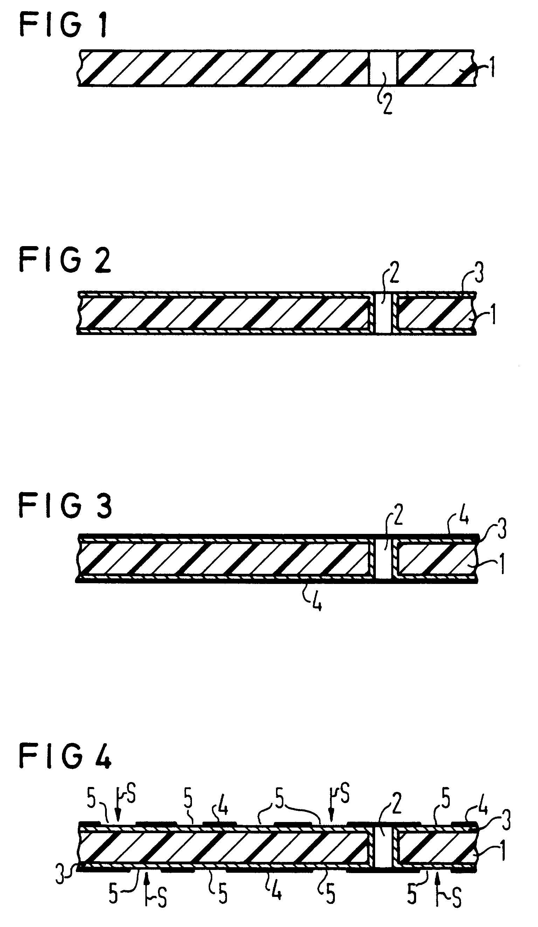

Die Figuren 1 bis 10 zeigen in stark vereinfachter schematischer Darstellung die verschiedenen Verfahrensstadien bei der Herstellung von Leiterplatten nach der Erfindung.

Bei dem in FIG 1 dargestellten Substrat 1 handelt es sich um einen Ausschnitt eines dreidimensionalen, d.h. schachtelförmigen oder abgewinkelten Basismaterials mit eingespritzten Durchkontaktierungslöchern 2. Als Materialien für die Substrate derartiger Leiterplatten sind insbesondere hochtemperaturbeständige Thermoplaste geeignet, wobei Polyetherimid oder Polyethersulfon als Beispiele genannt werden können. Im geschilderten Ausführungsbeispiel wurde glasfaserverstärktes Polyetherimid verwendet.

Das in FIG 1 dargestellte Substrat 1 wurde zunächst zur Erhöhung der Haftfestigkeit der später aufzubringenden Leiterbahnen und Durchkontaktierungen gebeizt und anschließend gereinigt. Dabei wurden sowohl für das Beizen als auch für die Reinigung des Substrats 1 handelsübliche Bäder verwendet, wobei das Beizbad speziell auf den Werkstoff Polyetherimid abgestimmt war.

Nach dem Beizen und Reinigen des Substrats 1 erfolgte dessen Bekeimung. Die in der Zeichnung nicht näher dargestellte Bekeimung wurde als dünne Schicht auf die Oberfläche des Substrats 1 und auf die Wandungen der Durchkontaktierungslöcher 2 aufgebracht. Das Aufbringen der Bekeimung erfolgt dabei durch Eintauchen des Substrats 1 in ein Pd Cl₂ - Sn Cl₂ - Bad. Für das Aufbringen der Bekeimung haben sich aber auch handelsübliche Bäder auf der Basis palladiumorganischer Verbindungen als geeignet erwiesen.

Nach dem Aufbringen der Bekeimung wurde diese aktiviert, wobei es sich hier um ein in der Additivtechnik übliches Reduzieren bwz. Beschleunigen handelt. Anschließend wurde gemäß FIG 2 durch außenstromlose chemische Metallabscheidung eine beispielsweise zwei Mikrometer starke erste Metallschicht 3 aufgebracht. Es ist ersichtlich, daß diese erste Metallschicht 3, die im geschilderten Ausführungsbeispiel in einem handelsüblichen stromlosen Kupferbad aufgebracht wurde, die Oberfläche des Substrats 1 und die Wandungen der Durchkontaktierungslöcher 2 überzieht.

Gemäß FIG 3 wurde dann auf die erste Metallschicht 3 durch stromlose Metallabscheidung eine Ätzresistschicht 4 aufgebracht, die im beschriebenen Ausführungsbeispiel aus Zinn besteht. Auch das Aufbringen der Ätzresistschicht 4 erfolgte durch außenstromlose chemische Metallabscheidung.

Cemäß FIG 4 wird die Ätzresistschicht 4 dann mit Hilfe eines Nd-YAG-Lasers in einem Scan-Verfahren strukturiert, wobei die Strahlung durch Pfeile S lediglich angedeutet ist. Es ist zu erkennen, daß die Entfernung der Ätzresistschicht 4 auf die unmittelbar an das spätere Leiterbild angrenzenden Bereiche 5 begrenzt ist. Die Entfernung der Ätzresistschicht 4 in diesen Bereichen 5 kann bereits durch eine einmalige Umfahrung bzw. Umschreibung des späteren Leiterbildes mit dem Laserstrahl bewirkt werden.

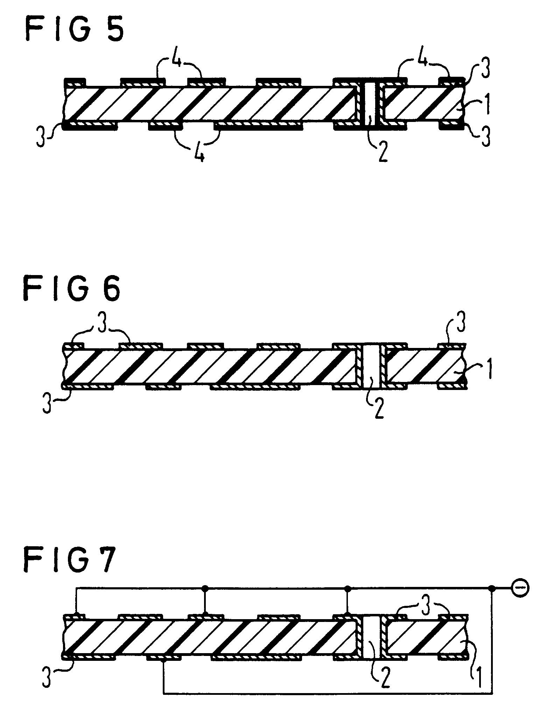

Nach der geschilderten selektiven Entfernung der Ätzresistschicht 4 wurden die hierbei freigelegten Bereiche der ersten Metallschicht 3 beispielsweise durch Sprühätzen oder Tauchätzen entfernt, wobei hierfür in der Subtrakivtechnik übliche Ätzlösungen eingesetzt werden können. Figur 5 zeigt, daß bei diesem Ätzschritt das spätere Leiterbild bereits entsteht, wobei allerdings zwischen den Leiterbahnen noch unerwünschte Bereiche der Metallschicht 3 verblieben sind.

Nach dem aus FIG 6 ersichtlichen Strippen der Ätzresistschicht 4 wurden die dem Leiterbild entsprechenden Bereiche der ersten Metallschicht 3 kathodisch kontaktiert. Diese kathodische Kontaktierung, die beispielsweise durch Klemmen, Kontaktbrücken oder dergleichen hergestellt wird, ist in FIG 7 rein schematisch dargestellt.

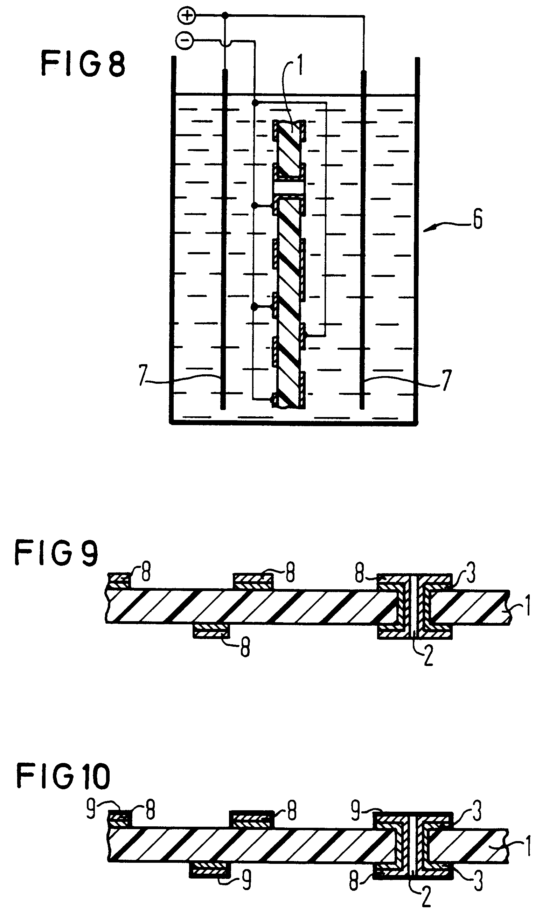

Gemäß FIG 8 wird die gesamte Leiterplatte, deren kathodische Kontaktierung durch ein Minuszeichen angedeutet ist, dann in ein galvanisches Metallabscheidungsbad 6 eingebracht. In diesem rein schematisch dargestellten galvanischen Metallabscheidungsbad 6 sind die mit dem Pluspol einer Stromquelle verbundenen Anoden 7 zu beiden Seiten der Leiterplatte angeordnet. Der Pluspol ist durch ein Pluszeichen angedeutet. In dem Metallabscheidungsbad 6 befindet sich im geschilderten Ausführungsbeispiel ein handelsübliches galvanisches Kupferbad. Derartige galvanische Kupferbäder werden beim additiven Aufbau von Leiterbahnen verwendet.

Gemäß FIG 9 wurde in dem vorstehend erwähnten galvanischen Hetallabscheidungsbad 6 auf die kathodisch kontaktierten Bereiche der ersten Metallschicht 3, d.h. auf die dem Leiterbild entsprechenden Bereiche der ersten Metallschicht 3, eine zweite Metallschicht 8 aufgebracht. Gleichzeitig mit der galvanischen Kupferabscheidung zum Aufbau des Leiterbildes, d.h. zum Aufbau von Leiterbahnen, Durchkontaktierungen 2, Anschlußflächen und dergleichen, wurden die nicht kathodisch kontaktierten Bereiche der ersten Metallschicht 3 in dem galvanischen Metallabscheidungsbad vollständig aufgelöst. Diese Auflösung der nicht dem Leiterbild entsprechenden, d.h. unerwünschten Bereiche der ersten Metallschicht 3 kann gegebenenfalls durch eine anodische Kontaktierung dieser Bereiche im Metallabscheidungsbad 6 beschleunigt werden. Gemäß FIG 10 kann auf die zweite Metallschicht 8 gegebenenfalls noch eine lötbare Oberfläche 9 aufgebracht werden, die im geschilderten Ausführungsbeispiel aus einer Zinn-Blei-Legierung bestand. Das Aufbringen der lötbaren Oberfläche 9 erfolgte in einem galvanischen Zinn-Blei-Abscheidungsbad, wobei hierbei die aus den FIG 7 und 8 erkennbare kathodische Kontaktierung ausgenutzt wurde.

Gemäß einer Variante des vorstehend beschriebenen Verfahrens wird auf die erste Metallschicht 3 durch Elektrotauchlackierung oder durch elektrostatische Beschichtung eine organische Ätzresistschicht 4 aufgebracht. Im Falle des Aufbringens dieser organischen Ätzresistschicht 4 durch Elektrotauchlackierung kann beispielsweise ein von der Firma Shipley unter dem Handelsnamen "Eagle TM" vertriebenes Resistmaterial verwendet werden. Die Strukturierung dieser organischen Ätzresistschicht 4 erfolgt dann auch hier wieder in einem Scan-Verfahren, so wie es in FIG 4 durch die Pfeile S angedeutet ist. Die Entfernung der organischen Ätzresistschlcht 4 gemäß FIG 6 erfolgt mit diesem Resistmaterial zugeordneten Strippern.

## Patentansprüche

1. Verfahren zur Herstellung von Leiterplatten, mit folgenden Verfahrensschritten:
a) auf ein elektrisch isolierendes Substrat (1) werden nacheinander eine erste Metallschicht (3) und eine Ätzresistschicht (4) aufgebracht;
b) die Ätzresistschicht (4) wird in den unmittelbar an das spätere Leiterbild angrenzenden Bereichen (5) mittels elektromagnetischer Strahlung (S) wieder entfernt;
c) die im Schritt b) freigelegten Bereiche der ersten Metallschicht (3) werden bis zur Oberfläche des Substrats (1) weggeätzt;
d) die dem Leiterbild entsprechenden Bereiche der ersten Metallschicht (3) oder der Ätzresistschicht (4) werden kathodisch kontaktiert;
e) auf die kathodisch kontaktierten Bereiche wird in einem galvanischen Metallabscheidungsbad (6) eine zweite Metallschicht (8) aufgebracht.

2. Verfahren nach Anspruch 1,
**dadurch gekennzeichnet,**
daß die erste Metallschicht (3) durch stromlose Metallabscheidung auf das Substrat (1) aufgebracht wird.

3. Verfahren nach Anspruch 1,
**dadurch gekennzeichnet,**
daß die erste Metallschicht (3) durch stromlose Abscheidung von Kupfer auf das Substrat (1) aufgebracht wird.

4. Verfahren nach Anspruch 1, 2 oder 3,
**dadurch gekennzeichnet,**
daß die erste Metallschicht (3) in einer Stärke von 0,5 bis 5 Mikrometern auf das Substrat 81) aufgebracht wird.

5. Verfahren nach einem der vorhergehenden Ansprüche,
**dadurch gekennzeichnet,**
daß für die Ätzresistschicht (4) Zinn oder eine Zinn-Blei-Legierung verwendet wird.

6. Verfahren nach einem der vorhergehenden Ansprüche,
**dadurch gekennzeichnet,**
daß die Ätzresistschicht (4) durch stromlose Metallabscheidung aufgebracht wird.

7. Verfahren nach einem der Ansprüche 1 bis 4,
**dadurch gekennzeichnet,**
daß für die Ätzresistschicht (4) ein organisches Material verwendet wird und daß die Ätzresistschicht (4) nach dem Schritt c) wieder entfernt wird.

8. Verfahren nach Anspruch 7,
**dadurch gekennzeichnet,**
daß die Ätzresistschicht durch Elektrotauchlackierung oder durch elektrostatische Beschichtung aufgebracht wird.

9. Verfahren nach einem der vorhergehenden Ansprüche,
**dadurch gekennzeichnet,**
daß die elektromagnetische Strahlung (S) durch einen Laser erzeugt wird.

10. Verfahren nach Anspruch 9,
**dadurch gekennzeichnet,**
daß die elektromagnetische Strahlung (S) durch einen Nd-YAG-Laser erzeugt wird.

11. Verfahren nach Anspruch 9 oder 10,
**dadurch gekennzeichnet,**
daß die Bewegung des Laserstrahls relativ zum Substrat (1) frei programmierbar ist.

12. Verfahren nach Anspruch 9, 10 oder 11,
**dadurch gekennzeichnet,**
daß die im Schritt b) vorgenommene Entfernung der an das Leiterbild angrenzenden Bereiche (5) der Ätzresistschicht (4) durch eine ein- oder zweimalige Umfahrung des späteren Leiterbildes mit einem Laserstrahl bewirkt wird.

13. Verfahren nach einem der vorhergehenden Ansprüche,
**dadurch gekennzeichnet,**
daß das Wegätzen gemäß Schritt c) durch Sprühätzen oder Tauchätzen vorgenommen wird.

14. Verfahren nach einem der Ansprüche 1 bis 6 oder 9 bis 13,
**dadurch gekennzeichnet,**
daß nach dem im Schritt c) vorgenommenen Ätzen die Ätzresistschicht (4) entfernt wird.

15. Verfahren nach einem der vorhergehenden Ansprüche,
**dadurch gekennzeichnet,** daß für die im Schritt e) aufgebrachte zweite Metallschicht (8) Kupfer verwendet wird.

16. Verfahren nach Anspruch 15,
**dadurch gekennzeichnet,**
daß auf die zweite Metallschicht (8) eine lötbare Oberfläche (9) aus einer Zinn-Blei-Legierung aufgebracht wird.

17. Verfahren nach Anspruch 16,
**dadurch gekennzeichnet,**
daß die lötbare Oberfläche (9) durch galvanische Metallabscheidung aufgebracht wird.

18. Verfahren nach einem der vorhergehenden Ansprüche,
**dadurch gekennzeichnet,**
daß ein dreidimensionales, spritzgegossenes Substrat (1) verwendet wird.

19. Verfahren nach Anspruch 18,
**dadurch gekennzeichnet,**
daß ein Substrat (1) mit eingespritzten Durchkontaktierungslöchern (2) verwendet wird.

20. Verfahren nach Anspruch 18 oder 19,
**dadurch gekennzeichnet,** daß für das Substrat (1) Polyetherimid oder Polyethersulfon verwendet wird.
